(19) Europäisches Patentamt
European Patent Office
Office européen des brevets

(11) **EP 2 464 005 B1**

(12) **FASCICULE DE BREVET EUROPEEN**

(45) Date de publication et mention
de la délivrance du brevet:
**23.10.2013 Bulletin 2013/43**

(51) Int Cl.:
***H03F 3/45*** (2006.01)

(21) Numéro de dépôt: **11191631.8**

(22) Date de dépôt: **01.12.2011**

(54) **Amplificateur différentiel de conversion asymétrique / symétrique**

Differentialverstärker zur asymmetrischen/symmetrischen Umwandlung

Differential amplifier for asymmetric / symmetric conversion

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.12.2010 FR 1004820**

(43) Date de publication de la demande:
**13.06.2012 Bulletin 2012/24**

(73) Titulaire: **Thales
92200 Neuilly Sur Seine (FR)**

(72) Inventeurs:
• **Corbiere, Rémi
78990 Elancourt (FR)**
• **Louis, Bruno
94100 Saint Maur (FR)**
• **Petit, Vincent
78550 Bazainville (FR)**

(74) Mandataire: **Lucas, Laurent Jacques et al
Marks & Clerk France
Conseils en Propriété Industrielle
Immeuble Visium
22, Avenue Aristide Briand
94117 Arcueil Cedex (FR)**

(56) Documents cités:
**US-A- 6 121 809        US-A1- 2002 175 763
US-A1- 2010 052 808**

• **SHUENN-YUH LEE ET AL: "A 1-V Wideband Low-Power CMOS Active Differential Power Splitter for Wireless Communication", IEEE TRANSACTIONS ON MICROWAVE THEORY AND TECHNIQUES, IEEE SERVICE CENTER, PISCATAWAY, NJ, US, vol. 55, no. 8, 1 août 2007 (2007-08-01), pages 1593-1600, XP011189941, ISSN: 0018-9480, DOI: DOI:10.1109/TMTT. 2007.901130**
• **XIN JIE WANG ET AL: "A Compensation Way for a Differential Pair to Achieve a High Performance Single-Ended to Differential Converter", ELECTRICAL AND COMPUTER ENGINEERING, 2007. CCECE 2007. CANADIAN CONFER ENCE ON, IEEE, PI, 1 avril 2007 (2007-04-01), pages 1137-1140, XP031176731, ISBN: 978-1-4244-1020-0**
• **SHOU-HSIEN WENG ET AL: "A DC-21 GHz Low Imbalance Active Balun Using Darlington Cell Technique for High Speed Data Communications", IEEE MICROWAVE AND WIRELESS COMPONENTS LETTERS, IEEE SERVICE CENTER, NEW YORK, NY, US, vol. 19, no. 11, 1 novembre 2009 (2009-11-01), pages 728-730, XP011278563, ISSN: 1531-1309, DOI: DOI:10.1109/LMWC.2009.2032017**

EP 2 464 005 B1

**Description**

L'invention concerne un amplificateur différentiel hyperfréquence à transistors pour conversion asymétrique/symétrique.

Les équipements radar et de guerre électronique embarqués comportent des dispositifs électroniques hyperfréquences tels que, des amplificateurs à faible bruit ou LNA à gain fixe ou variable (LNA pour Low Noise Amplifier en langue anglaise) et des déphaseurs vectoriels.

Ces dispositifs hyperfréquences comptent habituellement des entrées de signaux hyperfréquences symétriques et doivent être parfois raccordés à des accès asymétriques de signaux, par exemple, c'est le cas de signaux provenant d'une antenne de réception véhiculés transmis par une ligne coaxiale asymétrique.

La conversion asymétrique/symétrique d'entrée de dispositifs hyperfréquences de réception est habituellement réalisée par un transformateur de couplage passif par inductances dit BALUN, contraction des termes en langue anglaise BALanced/UNbalanced.

Un tel transformateur de type BALUN à l'entrée d'un dispositif hyperfréquence s'accompagne d'une augmentation importante de la surface d'implantation de ce dernier aux fréquences de quelques GHz. De plus, le transformateur BALUN étant généralement accordé à une fréquence prédéterminée, il fonctionne par conséquent en bande étroite et limite la bande de fonctionnement du dispositif hyperfréquence auquel il est associé. En outre, le facteur du bruit du récepteur s'en trouve dégradé par les pertes du BALUN.

D'autres solutions de type actif à transistors, pour symétriser l'entrée de signal, sont utilisées dans les dispositifs hyperfréquences de l'état de l'art. Ces solutions sont basées sur des technologies GaAs (ou Arséniure de Gallium) ayant pour avantage de présenter de très bonnes performances intrinsèques de linéarité et de bruit mais en contrepartie présentant comme inconvénient un coût de fabrication élevé avec une faible possibilité d'intégration avec ses circuits annexes de commande, de polarisation des transistors. Par conséquent, ces limitations freinent la possibilité de miniaturisation de tels circuits. De plus, ces inconvénients compliquent l'architecture des systèmes hyperfréquences et pénalisent le coût des équipements.

L'utilisation des technologies de type SiGe (Silicium/Germanium) pour la réalisation de fonctions hyperfréquences, techniques développées principalement pour des applications civiles telles que le GPS (Global Positioning System, en langue anglaise) l'UMTS ou le WLAN, permettent de bénéficier d'une réduction du coût des circuits intégrés comportant ces fonctions hyperfréquences, rendant possible, entre autres, une intégration des interfaces et des polarisations des transistors de la puce, la suppression des alimentations de potentiel négatif, la réduction de la consommation des circuits, un rendement de fabrication élevé et une bonne reproductibilité des performances.

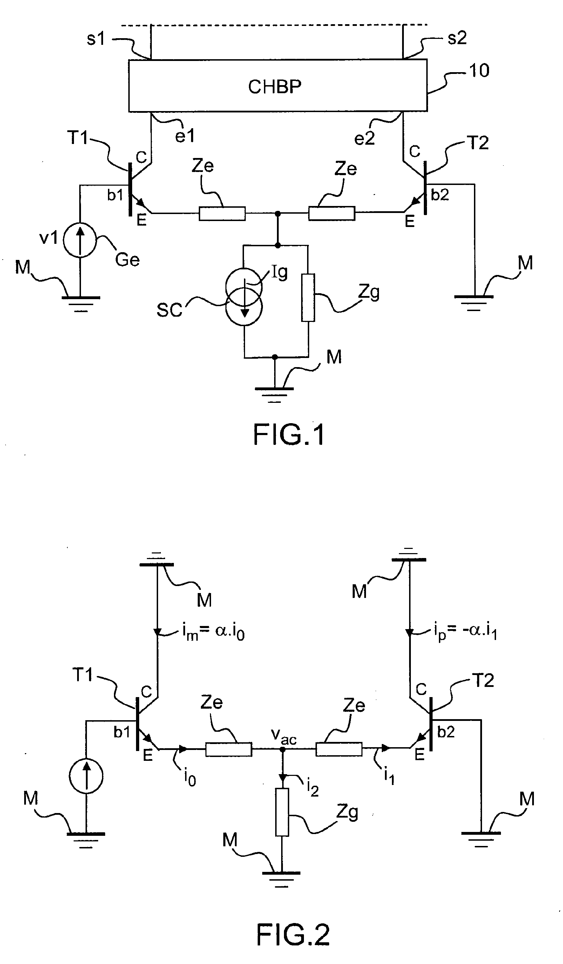

La figure 1 montre un schéma de principe d'un montage élémentaire différentiel de conversion de l'état de l'art constitué par une paire différentielle de transistors T1, T2 en émetteurs communs. Les émetteurs E des deux transistors T1, T2 sont reliés par deux impédances Ze de contre-réaction en série. La polarisation des deux transistors est assurée par un générateur de courant Ig parfait SC connecté entre le point commun des deux impédances Ze de contre-réaction et le potentiel de référence M. Le générateur de courant parfait SC comporte une impédance Zg entre ses deux bornes pour simuler un générateur de courant réel.

La polarisation en tension des transistors T1, T2 par les collecteurs C est effectuée par un dispositif non représenté sur la figure 1.

Les collecteurs C des deux transistors T1, T2 sont connectés à une charge basse impédance (non représentée sur la figure 1) à travers un étage d'adaptation CHBP (10) de type montage cascode à sorties s1, s2 symétriques.

L'attaque dynamique de l'amplificateur différentiel se fait de manière asymétrique par un générateur Ge de tension v1 entre la base b1 du transistor T1 et le potentiel de référence M. La base b2 du transistor T2 est mise au potentiel de référence M.

Le principal inconvénient de ce type d'amplificateur différentiel de l'état de l'art est la dégradation de réjection du mode commun du fait de l'impédance Zg, ce qui entraine la dissymétrie des courants de collecteurs en fonction de la fréquence F de fonctionnement.

Plusieurs solutions a ce problème peuvent être trouvées dans les documents de brevet US 2002/175763, US 6,121,809 et US 2010/052808, et dans Shuenn-Yuh et al., "A 1-V Wideband Low-Power CMOS Active Differential Power Splitter for Wireless Communication" (IEEE Transactions On Microwave Theory and Techniques, 2007), Xin Jie et al., "A Compensation Way for a Differential Pair to Achieve a High Performance Single-Ended to Differential Converter" (Electrical And Computer Engineering, CCECE, 2007) et Shou-Hsien et al., "A DC-21 GHz Low Imbalance Active Balun Using Darlington Cell Technique for High Speed Data Communications" (IEEE Microwave and Wireless Components Letters, 2009).

Pour pallier les inconvénients des dispositifs différentiels de l'état de l'art l'invention propose un amplificateur différentiel de conversion asymétrique/symétrique comportant une entrée de signal v1 de type asymétrique par rapport à un potentiel de référence et une sortie de signal de type symétrique. L'amplificateur différentiel comprend deux transistors bipolaires T1, T2 montés en émetteurs communs. Les émetteurs E des deux transistors T1, T2 sont reliés par deux impédances de contre-réaction en série. Un générateur de courant Ig parfait et une impédance Zg aux bornes du générateur de courant Ig sont connectés entre le point commun des deux impédances de contre-réaction et le potentiel de référence. L'entrée de signal v1 est connectée à la base du transistor T1. La base du transistor T2 est reliée au potentiel de référence pour former avec la base du transistor T1 l'entrée asymétrique. La sortie symétrique est réalisée par les collecteurs des deux transistors T1, T2 à travers un étage d'adaptation CHBP d'impédance de la sortie.

Une impédance $Z_{corr}$ de contre-réaction de correction est connectée entre le collecteur du transistor T2 et la base du transistor T1 pour symétriser les courants des collecteurs des deux transistors T1, T2. La valeur de ladite impédance de contre-réaction de correction $Z_{corr}$ est définie par :

$$Z_{corr} = 2 \cdot Zg$$

Avantageusement les deux transistors T1, T2 sont choisis soit de type PNP soit de type NPN.

Dans une réalisation, l'étage d'adaptation CHBP est de type cascode abaisseur d'impédance.

L'invention concerne aussi un amplificateur différentiel de conversion asymétrique/symétrique comportant une entrée de signal v1 de type asymétrique par rapport à un potentiel de référence et une sortie de signal de type symétrique. L'amplificateur différentiel comprend deux transistors MOS FET T1, T2 en sources communes. Les sources des deux transistors sont reliées par deux impédances de contre-réaction en série. Un générateur de courant Ig parfait et une impédance $Z_g$ aux bornes du générateur de courant Ig sont connectés entre le point commun des deux impédances de contre-réaction et le potentiel de référence. L'entrée de signal v1 est connectée à la grille du transistor T1. La grille du transistor T2 est reliée au potentiel de référence pour former avec la grille du transistor T1 l'entrée asymétrique. La sortie symétrique est réalisée par les drains des deux transistors T1, T2 à travers un étage d'adaptation CHBP d'impédance de sortie.

Une impédance $Z_{corr}$ de contre-réaction de correction est connectée entre le drain du transistor T2 et la base du transistor T1 pour symétriser les courants des drains des deux transistors T1, T2. La valeur de ladite impédance de contre-réaction de correction $Z_{corr}$ est définie par :

$$Z_{corr} = 2 \cdot Zg$$

Une principale caractéristique de l'amplificateur différentiel de conversion, selon l'invention, réside dans l'égalisation des courants des collecteurs du transistor T1 et du transistor T2 dans le cas des transistors bipolaires ou l'égalisation des courants des drains dans le cas des transistors de type MOSFET.

Un principal but de l'amplificateur, selon l'invention, est une amélioration de la réjection du mode commun et des performances de bande passante de l'amplificateur différentiel de conversion.

Un autre but est la reproductibilité des performances dans la fabrication en série de l'amplificateur différentiel et une diminution de son coût de fabrication.

L'invention sera mieux comprise par la description d'exemples de réalisation d'amplificateurs différentiels de conversion asymétrique/symétrique en référence aux dessins indexés dans lesquels :

- la figure 1, déjà décrite, montre un schéma de principe d'un montage élémentaire différentiel de conversion de l'état de l'art ;
- la figure 2 montre un schéma équivalent du circuit de la figure 1 en fonctionnement aux petits signaux ;
- la figure 3 montre un amplificateur différentiel de conversion asymétrique/symétrique selon l'invention ;
- les figures 4a, 4b et 4b montrent des courants collecteurs $i_m$ et ip des transistors de l'amplificateur différentiel de la figure 2 ;
- la figure 5 montre les courants collecteurs de l'amplificateur différentiel de la figure 3.

Dans un premier temps, dans la suite de la description, la dissymétrie des courants des collecteurs des transistors est mise en évidence dans les amplificateurs différentiels de l'état de l'art. Comme cela a été dit précédemment cette dissymétrie des courants collecteurs est responsable de la dégradation des performances de la paire différentielle comportant les deux transistors T1 et T2.

Dans un deuxième temps est décrite la méthode et la réalisation d'un amplificateur différentiel de conversion asymétrique/symétrique selon l'invention permettant de s'affranchir en première approximation de cette dissymétrie des courants collecteurs afin de retrouver les performances optimales de la paire différentielle.

La figure 2 montre un schéma équivalent du circuit de la figure 1 en fonctionnement aux petits signaux.

Aux petits signaux, les générateurs de tension continue DC de polarisation des collecteurs des transistors se comportent comme des courts circuits mettant les collecteurs C des transistors au potentiel de référence M.

En se référant au schéma équivalent de la figure 2, les courants dans les collecteurs et dans les émetteurs des transistors T1, T2 sont exprimés par :

$$i_1 = i_0 - i_2$$

$$i_2 = \frac{v_{ac}}{Z_c} \quad \text{et} \quad \alpha = \frac{\beta}{\beta+1}$$

Avec :

$i_0$ courant petits signaux de l'émetteur du transistor T1
$i_1$, courant petits signaux de l'émetteur du transistor T2
$i_2$ courant petits signaux dans l'impédance Zg du générateur de courant SC,
$\alpha$ rapport entre le courant d'émetteur et le courant collecteur du transistor,
$\beta$ gain en courant du transistor,
$v_{ac}$ tension aux bornes de l'impédance Zg du générateur de courant SC.

La branche de commande base-émetteur de l'amplificateur différentiel se réduit à l'impédance d'entrée $h_{11e}$ du transistor T1 aux petits signaux.

En se référent à l'amplificateur différentiel de l'état de l'art des figures 1 et 2, il est possible de déterminer le schéma équivalent de Thévenin entre les bases b1, b2 des transistors T1, T2 et d'en exprimer le courant $i_2$ au travers de l'impédance Zg du générateur de courant SC, à partir de l'impédance d'entrée $h_{11e}$ du transistor T1 et de la contre-réaction Ze,

$$i_2 = \frac{v1}{2} \cdot \frac{1}{\dfrac{h_{11e}}{2} + \dfrac{Ze}{2} + Zg}$$

En première approximation, si l'on néglige $\dfrac{h_{11e}}{2}$ et $\dfrac{Ze}{2}$ devant $Z_g$ alors le courant dans l'impédance $Z_g$ de la source de courant devient :

$$i_2 \cong \frac{v1}{2 \cdot Zg}$$

Le courant collecteur $i_m$, du transistor T1 et le courant collecteur $i_p$ du transistor T2 s'écriront donc :

$$i_m = \alpha \cdot i_0$$

$$i_p = -\alpha \cdot i_1 = -\alpha \left[ i_0 - i_2 \right] = -\alpha \left[ i_0 - \frac{v1}{2 \cdot Zg} \right] =$$

$$-\alpha \cdot i_0 + \alpha \cdot \frac{v1}{2 \cdot Zg} = i_m + \alpha \cdot \frac{v1}{2 \cdot Zg} \quad (3)$$

L'expression (3) montre que le courant collecteur $i_m$ du transistor T1 est identique au courant collecteur ip du transistor T2 au terme

$$\alpha \cdot \frac{v1}{2 \cdot Zg}$$

près.

Il est à noter que les courants de collecteurs $i_m$ et $i_p$ sont en opposition de phase.

Dans les amplificateurs différentiels de l'état de l'art on cherche à augmenter au maximum l'impédance $Z_g$ du générateur de courant SC de façon à faire tendre le terme $\alpha \cdot \dfrac{v1}{2 \cdot Zg}$ vers une valeur nulle et obtenir ainsi une symétrie des courants collecteurs $i_m$ et $i_p$ de la paire différentielle T1, T2. Néanmoins l'impédance Zg du générateur de courant SC ne peut en pratique être de valeur très grande notamment du fait des fréquences de travail F importantes de l'ordre de quelques GHz. En effet il s'agit de l'impédance équivalente d'un miroir de courant qui à ces fréquences de travail présente une impédance trop faible pour assurer une bonne symétrie des courants des collecteurs des deux transistors T1, T2. En outre cette impédance $Z_g$ chute avec la fréquence F de travail.

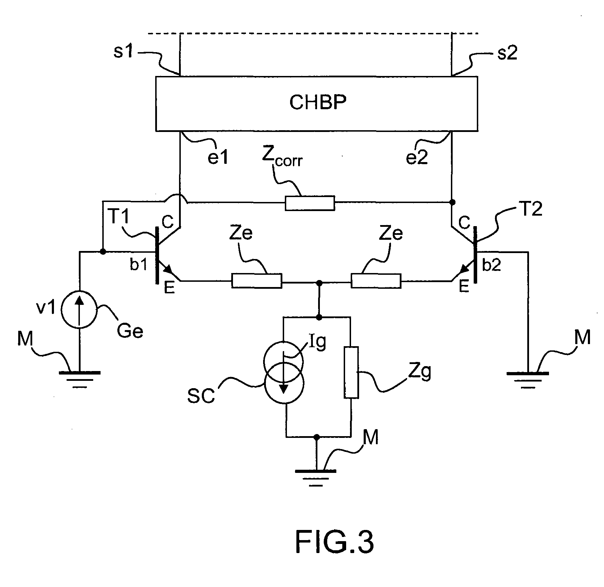

La figure 3 montre un amplificateur différentiel de conversion asymétrique/symétrique tel que représenté à la figure 2 et comportant, en outre, selon une principale caractéristique de l'invention, un circuit de contre-réaction pour égaliser les courants collecteurs des transistors. Le circuit de contre-réaction est une impédance *Zcorr* de contre-réaction de correction connectée entre le collecteur C du transistor T2 et la base b1 du transistor T1.

Le principe utilisé dans l'amplificateur différentiel selon l'invention, tel que représenté à la figure 3, consiste à égaliser les courants collecteurs $i_m$, $i_p$ des deux transistors T1, T2 par compensation du terme $\alpha \cdot \dfrac{v1}{2 \cdot Zg}$. On a les courants collecteurs $i_m''$ et $i_p''$ dans la configuration de la figure 3 avec compensation :

$$i_m'' = i_m = \alpha \cdot i_0$$

$$i_p'' = -i_m = -\alpha \cdot i_0 = \alpha \cdot i_0 + \alpha \cdot i_2 - \alpha \cdot i_2 = i_p - \alpha \cdot i_2 = i_p - \alpha \cdot \frac{v1}{2 \cdot Zg}$$

$i_m''$ étant le courant dans le collecteur de T1

$i_p''$ étant le courant dans le collecteur de T2

Cette approche permet de conserver le courant $i_m$ dans le collecteur de T1 et le circuit de contre-réaction de correction permet d'injecter dans le collecteur du transistor T2 un courant de correction $i_{corr}$ tel que :

$$i_{corr} = -\alpha \cdot i_2 = -\alpha \cdot \frac{v1}{2 \cdot Zg} \quad (4)$$

Le terme $\dfrac{v1}{2 \cdot Zg}$ représente une contre-réaction locale de la base b1 du transistor T1 au collecteur C du transistor T2 au terme $\alpha$ près ($\alpha$ étant très proche de 1).

Ainsi le courant de correction $i_{corr}$ a comme expression

$$i_{corr} = -\frac{v1}{Zcorr} \quad (5)$$

$Zcorr$ représente l'impédance de contre-réaction de correction.

Finalement par identification des deux expressions (4) et (5) l'égalité des courants collecteurs dans les deux transistors T1, T2 est obtenue si, et seulement si, l'impédance de contre-réaction de correction $Zcorr$ vaut deux fois l'impédance $Z_g$ du générateur de courant SC.

$$Z_{corr} = 2 \cdot Zg$$

Afin de valider les développements théoriques exprimés précédemment, une série de simulations a été réalisée avec un amplificateur différentiel de l'état de l'art montrant l'influence de l'impédance Zg du générateur de courant sur la symétrie des courants dans les collecteurs des transistors T1 et T2.

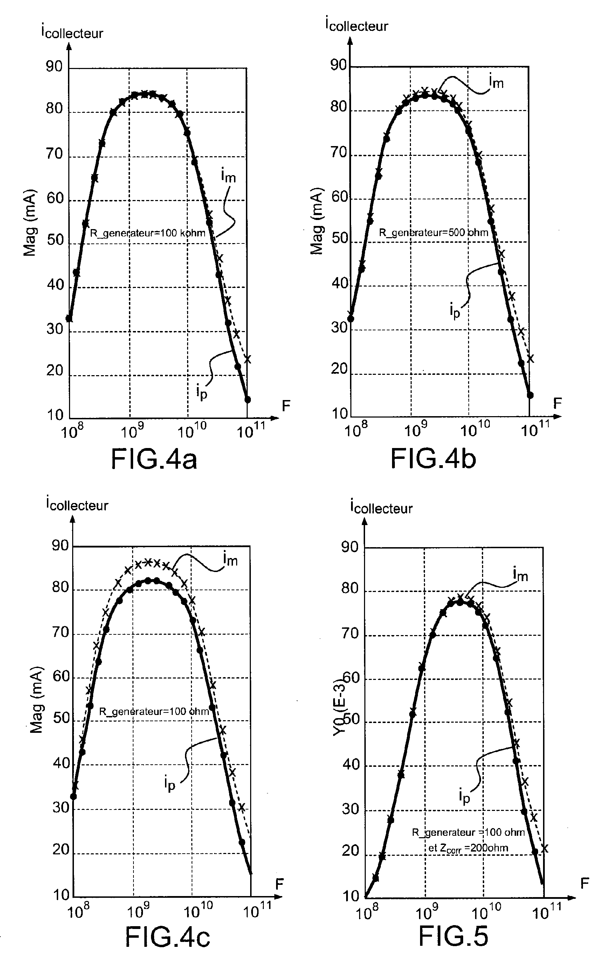

Les figures 4a, 4b et 4b montrent les courants collecteurs $i_m$ et ip des transistors de l'amplificateur différentiel de la figure 2, en fonction de l'impédance Zg du générateur de courant SC.

La figure 4a montre la variation des courants collecteurs $i_m$ et ip en fonction de la fréquence F de fonctionnement de l'amplificateur différentiel de l'état de l'art, pour une impédance Zg du générateur de courant de 100KΩ. La superposition des courants collecteurs est respectée jusqu'à une fréquence F de 20GHz. Au-delà, les effets capacitifs des transistors se font ressentir notamment sur le transistor T2, ce qui a pour effet de diminuer son gain en courant $\beta$. Ainsi le terme définissant le rapport $\dfrac{\beta}{\beta+1}$ caractérisant la probabilité de disparition d'un électron dans la base du transistor sera plus faible pour T1 que pour T2 entraînant par conséquent un courant collecteur $i_p$ plus faible que le courant collecteur $i_m$.

La figure 4b montre la variation des courants collecteurs $i_m$ et ip en fonction de la fréquence F de fonctionnement de l'amplificateur différentiel de l'état de l'art pour une impédance Zg du générateur de courant de 500Ω. Les différences des courants collecteurs sont identiques à celles de la figure 4a à haute fréquence mais l'écart s'accentue entre 1GHz et 20 GHz. L'influence de la valeur de l'impédance Zg du générateur de courant est ainsi directement plus significative aux fréquences intermédiaires entre 1 GHz et 20 GHz.

La figure 4c montre la variations des courants collecteurs $i_m$ et ip en fonction de la fréquence F de fonctionnement de l'amplificateur différentiel de l'état de l'art pour une impédance Zg du générateur de courant encore plus faible de 100Ω. L'écart entre les courants de collecteur et donc la dégradation des performances de l'amplificateur différentiel est encore plus significatif aux fréquences intermédiaires.

La contre-réaction de correction dans l'amplificateur différentiel selon l'invention permet de compenser une faible impédance Zg de l'ordre de 100Ω du générateur de courant SC qui représente l'ordre de grandeur de l'impédance équivalente d'un miroir de courant à ces fréquences.

Selon l'invention et pour compenser l'écart des courant collecteurs une résistance $Z_{corr}$ = 2·100Ω, soit 200Ω, est insérée entre la base b1 du transistor T1 et le collecteur C du transistor T2.

La figure 5 montre les courants collecteurs de l'amplificateur différentiel, selon l'invention, de la figure 3 en fonction de la fréquence de travail F dans le cas d'une impédance Zg=100 Ω du générateur de courant SC. Les courants de collecteur $i_m$ et ip sont quasiment confondus en fonction de la fréquence de travail F à comparer aux courants des collecteurs des courbes de la figure 4c, sans compensation de l'impédance Zg du générateur de courant, présentant une grande dissymétrie.

Ce résultat représenté à la figure 5 permet de confirmer l'amélioration de la symétrie des courants de la paire différentielle par compensation du courant de fuite occasionné par une faible impédance du générateur de courant SC assurant la polarisation de l'amplificateur différentiel.

L'amplificateur différentiel de conversion asymétrique/symétrique, selon l'invention, n'est pas limité aux transistors bipolaires T1, T2. Des transistors de type MOSFET peuvent être aussi utilisés pour réaliser l'amplificateur avec la contre réaction $Z_{corr}$ de correction. Dans le cas de transistors MOSFET, les sources sont connectées au générateur de courant SC, les drains étant les sorties symétriques de l'amplificateur. La contré-réaction de correction par la résistance $Z_{corr}$ est alors réalisée entre la grille du transistor T1 et le drain du transistor T2.

La nouvelle approche selon l'invention permet donc de s'affranchir de l'utilisation d'un dispositif de conversion de type passif tel que le BALUN qui s'accompagne d'une dégradation des performances de la structure différentielle mais aussi d'une surface d'implantation importante.

## Revendications

1. Amplificateur différentiel de conversion asymétrique/symétrique comportant une entrée (b1) de signal v1 de type asymétrique par rapport à un potentiel de référence (M) et une sortie (s1, s2) de signal de type symétrique, l'amplificateur différentiel comprenant deux transistors bipolaires T1, T2 montés en émetteurs communs, les émetteurs E des deux transistors T1, T2 étant reliés par deux impédances de contre-réaction en série, un générateur de courant Ig parfait et une impédance $Z_g$ aux bornes du générateur de courant Ig étant connectés entre le point commun des deux impédances de contre-réaction et le potentiel de référence, l'entrée de signal v1 étant connectée à la base du transistor T1, la base du transistor T2 étant reliée au potentiel de référence pour former avec la base du transistor T1 l'entrée asymétrique, la sortie symétrique étant réalisée par les collecteurs des deux transistor T1, T2 à travers un étage d'adaptation CHBP d'impédance de la sortie (s1, s2),
caractérisé en ce qu'il comporte une impédance $Z_{corr}$ de contre-réaction de correction connectée entre le collecteur du transistor T2 et la base du transistor T1 pour symétriser les courants des collecteurs des deux transistors T1, T2, la valeur de ladite impédance de contre-réaction de correction $Z_{corr}$ étant définie par :

$$Z_{corr} = 2 \cdot Zg$$

2. Amplificateur différentiel selon la revendication 1, caractérisé en ce que les deux transistors T1, T2 sont choisis soit de type PNP soit de type NPN.

3. Amplificateur différentiel selon la revendication 4, caractérisé en ce que l'étage d'adaptation CHBP (10) est de type cascode abaisseur d'impédance.

4. Amplificateur différentiel de conversion asymétrique/symétrique comportant une entrée (b1) de signal v1 de type asymétrique par rapport à un potentiel de référence (M) et une sortie de signal de type symétrique, l'amplificateur différentiel comprenant deux transistors MOS FET T1, T2 en sources communes, les sources des deux transistors étant reliées par deux impédances de contre-réaction en série, un générateur de courant Ig parfait et une impédance $Z_g$ aux bornes du générateur de courant Ig étant connectés entre le point commun des deux impédances de contre-réaction et le potentiel de référence, l'entrée de signal v1 étant connectée à la grille du transistor T1, la grille du transistor T2 étant reliée au potentiel de référence pour former avec la grille du transistor T1 l'entrée asymétrique, la sortie symétrique étant réalisée par les drains des deux transistor T1, T2 à travers un étage d'adaptation CHBP d'impédance de la sortie (s1, s2),
caractérisé en ce qu'il comporte une impédance $Z_{corr}$ de contre-réaction de correction connectée entre le drain du transistor T2 et la base du transistor T1 pour symétriser les courants des drains des deux transistors T1, T2, la valeur de ladite impédance de contre-réaction de correction $Z_{corr}$ étant définie par :

$$Z_{corr} = 2 \cdot Zg$$

**Patentansprüche**

1. Differentialverstärker zur asymmetrischen/symmetrischen Umwandlung, der einen Signal-v1-Eingang (b1) des asymmetrischen Typs in Bezug auf ein Referenzpotential (M) und einen Signalausgang (s1, s2) des symmetrischen Typs umfasst, wobei der Differentialverstärker zwei als gemeinsame Sender wirkende bipolare Transistoren T1, T2 umfasst, wobei die Sender E der beiden Transistoren T1, T2 durch zwei Rückkopplungsimpedanzen in Serie geschaltet sind, wobei ein perfekter Stromgenerator Ig und eine Impedanz Zg an den Anschlüssen des Stromgenerators Ig zwischen dem gemeinsamen Punkt der beiden Rückkopplungsimpedanzen und dem Referenzpotential geschaltet sind, wobei der Signal-v1-Eingang mit der Basis des Transistors T1 verbunden ist, wobei die Basis des Transistors T2 mit dem Referenzpotential verbunden ist, um mit der Basis des Transistors T1 den asymmetrischen Eingang zu bilden, wobei der symmetrische Ausgang von den Kollektoren der beiden Transistoren T1, T2 durch eine Impedanzanpassungsstufe CHBP des Ausgangs (s1, s2) realisiert wird,
**dadurch gekennzeichnet, dass** er eine Korrekturrückkopplungsimpedanz $Z_{corr}$ aufweist, die zwischen dem Kollektor des Transistors T2 und der Basis des Transistors T1 geschaltet ist, um die Ströme der Kollektoren der beiden Transistoren T1, T2 symmetrisch zu machen, wobei der Wert der Korrekturrückkopplungsimpedanz $Z_{corr}$ durch $Z_{corr}$ = 2 Zg definiert wird.

2. Differentialverstärker nach Anspruch 1, **dadurch gekennzeichnet, dass** die beiden Transistoren T1, T2 entweder vom PNP-Typ oder vom NPN-Typ gewählt werden.

3. Differentialverstärker nach Anspruch 4, **dadurch gekennzeichnet, dass** die Anpassungsstufe CHBP (10) vom Impedanzreduktionskaskodentyp ist.

4. Differentialverstärker zur asymmetrischen/symmetrischen Umwandlung, der einen Signal-v1-Eingang (b1) des asymmetrischen Typs in Bezug auf ein Referenzpotential (M) und einen Signalausgang des symmetrischen Typs umfasst, wobei der Differentialverstärker zwei MOSFET-Transistoren T1, T2 als gemeinsame Sources umfasst, wobei die Sources der beiden Transistoren durch zwei Rückkopplungsimpedanzen in Serie geschaltet sind, wobei ein perfekter Stromgenerator Ig und eine Impedanz Zg an den Anschlüssen des Stromgenerators zwischen dem gemeinsamen Punkt der beiden Rückkopplungsimpedanzen und dem Referenzpotential geschaltet sind, wobei der Signal-v1-Eingang mit dem Gatter des Transistors T1 verbunden ist, wobei das Gatter des Transistors T2 mit dem Referenzpotential verbunden ist, um mit dem Gatter des Transistors T1 den asymmetrischen Eingang zu bilden, wobei der symmetrische Ausgang von den Drains der beiden Transistoren T1, T2 durch eine Impedanzanpassungsstufe CHBP des Ausgangs (s1, s2) realisiert wird,
**dadurch gekennzeichnet, dass** er eine Korrekturrückkopplungsimpedanz $Z_{corr}$ umfasst, die zwischen dem Drain des Transistors T2 und der Basis des Transistors T1 geschaltet ist, um die Ströme der Drains der beiden Transistoren T1, T2 symmetrisch zu machen, wobei der Wert der Korrekturrückkopplungsimpedanz $Z_{corr}$ durch $Z_{corr}$ = 2 Zg definiert wird.

**Claims**

1. A differential amplifier for asymmetric/symmetric conversion comprising a signal v1 input (b1) of the asymmetric type relative to a reference potential (M) and a signal output (s1, s2) of the symmetric type, said differential amplifier comprising two bipolar transistors T1, T2 mounted as common transmitters, the transmitters E of said two transistors T1, T2 being connected in series by two feedback impedances, one perfect current generator Ig and one impedance Zg at the terminals of said current generator Ig being connected between the common point of said two feedback impedances and said reference potential, the signal v1 input being connected to the base of said transistor T1, the base of said transistor T2 being connected to said reference potential so as to form, with the base of said transistor T1, the asymmetric input, the symmetric output being realised by the collectors of said two transistors T1, T2 through an impedance matching stage CHBP of said output (s1, s2),
**characterised in that** it comprises a correction feedback impedance $Z_{corr}$ connected between the collector of said transistor T2 and the base of said transistor T1 to make the currents of the collectors of said two transistors T1, T2 symmetric, the value of said correction feedback impedance $Z_{corr}$ being defined by:

$$Z_{corr} = 2 \cdot Zg.$$

2. The differential amplifier according to claim 1, **characterised in that** said two transistors T1, T2 are selected either from the PNP type or from the NPN type.

3. The differential amplifier according to claim 4, **characterised in that** said matching stage CHBP (10) is of the impedance reduction cascode type.

4. A differential amplifier for asymmetric/symmetric conversion comprising a signal v1 input (b1) of the asymmetric type relative to a reference potential (M) and a signal output of the symmetric type, said differential amplifier comprising two MOS FET transistors T1, T2 as common sources, the sources of said two transistors being connected in series by two feedback impedances, one perfect current generator Ig and one impedance Zg at the terminals of said current generator being connected between the common point of said two feedback impedances and said reference potential, the signal v1 input being connected to the gate of said transistor T1, the gate of said transistor T2 being connected to said reference potential so as to form, with the gate of said transistor T1, the asymmetric input, the symmetric output being realised by the drains of said two transistors T1, T2 through an impedance matching stage CHBP of said output (s1, s2),

**characterised in that** it comprises a correction feedback impedance $Z_{corr}$ connected between the drain of said transistor T2 and the base of said transistor T1 to make the currents of the drains of said two transistors T1, T2 symmetric, the value of said correction feedback impedance $Z_{corr}$ being defined by:

$$Z_{corr} = 2 \cdot Zg.$$

FIG.1

FIG.2

FIG.3

FIG.4a

FIG.4b

FIG.4c

FIG.5

## RÉFÉRENCES CITÉES DANS LA DESCRIPTION

**Documents brevets cités dans la description**

- US 2002175763 A
- US 6121809 A
- US 2010052808 A

**Littérature non-brevet citée dans la description**

- **SHUENN-YUH et al.** A 1-V Wideband Low-Power CMOS Active Differential Power Splitter for Wireless Communication. *IEEE Transactions On Microwave Theory and Techniques,* 2007
- **XIN JIE et al.** A Compensation Way for a Differential Pair to Achieve a High Performance Single-Ended to Differential Converter. *Electrical And Computer Engineering, CCECE,* 2007
- **SHOU-HSIEN et al.** A DC-21 GHz Low Imbalance Active Balun Using Darlington Cell Technique for High Speed Data Communications. *IEEE Microwave and Wireless Components Letters,* 2009